# EUROPÄISCHE PATENTSCHRIFT

(11) **EP 3 830 937 B1**
(45) Veröffentlichungstag und Bekanntmachung des Hinweises auf die Patenterteilung: **28.10.2026**
(21) Anmeldenummer: 19778812.8
(22) Anmeldetag: 10.09.2019
(51) Int. Cl.: H02M 1/14, H02P 29/50, G01R 27/16, H02M 5/42, H02M 5/458, H02M 1/32, G01R 31/42

(54) **VERFAHREN ZUM ÜBERWACHEN EINES SAUGKREISES EINES STROMRICHTERSYSTEMS**
METHOD FOR MONITORING AN ABSORPTION CIRCUIT OF A CONVERTER SYSTEM
PROCÉDÉ DESTINÉ À SURVEILLER UN FILTRE COUPE-BANDE D'UN SYSTÈME DE CONVERTISSEUR

(30) Priorität: 13.09.2018 DE 102018215594
(43) Veröffentlichungstag der Anmeldung: 09.06.2021
(73) Patentinhaber: Siemens Mobility GmbH, 80997 München (DE)
(72) Erfinder: HAAF, Stefan, 97253 Gaukönigshofen (DE); LOREK, Philipp, 91058 Erlangen (DE)
(74) Vertreter: Siemens Patent Attorneys
(86) Internationale Anmeldenummer: PCT/EP2019/074037
(87) Internationale Veröffentlichungsnummer: WO 2020/053175

(56) Entgegenhaltungen:
- DE-A1- 102005 004 697
- VASAN ARVIND SAI SARATHI ET AL: "Health assessment of electronic systems", 2013 INTERNATIONAL CONFERENCE ON QUALITY, RELIABILITY, RISK, MAINTENANCE, AND SAFETY ENGINEERING (QR2MSE), IEEE, 15 July 2013 (2013-07-15), pages 1689 - 1694, XP032498982, DOI: 10.1109/QR2MSE.2013.6625901
- YAOW-MING CHEN ET AL: "Online Failure Prediction of the Electrolytic Capacitor for LC Filter of Switching-Mode Power Converters", IEEE TRANSACTIONS ON INDUSTRIAL ELECTRONICS, IEEE SERVICE CENTER, PISCATAWAY, NJ, USA, vol. 54, no. 1, 1 January 2008 (2008-01-01), pages 400 - 406, XP011197990, ISSN: 0278-0046

## Beschreibung

Die Erfindung betrifft ein Verfahren zum Überwachen einer Abstimmung eines in einem Zwischenkreis eines Stromrichtersystems angeordneten Saugkreises, wobei der Zwischenkreis zwischen einen Eingangs-Stromrichter und einen Ausgangs-Stromrichter des Stromrichtersystems zwischengeschaltet ist.

Als Beispiel kann ein Stromrichtersystem für ein Schienenfahrzeug genannt werden.

Zum Betreiben eines Schienenfahrzeugs wird eine Wechselspannung aus einer Oberleitung bzw. allgemein aus einem Stromnetz mittels des Eingangs-Stromrichters in eine Gleichspannung umgewandelt. Die Gleichspannung wiederum wird mittels des Ausgangs-Stromrichters beispielsweise in ein dreiphasiges Drehfeld zum Betreiben des Motors des Schienenfahrzeugs gewandelt.

Der Eingangs-Stromrichter kann z.B. ein aktiver Vierquadrantensteller und/oder ein passiver Diodengleichrichter sein. Weiter kann der Ausgangs-Stromrichter z.B. ein Pulswechselrichter sein.

Der zwischen den Eingangs-Stromrichter und den Ausgangs-Stromrichter zwischengeschaltete Zwischenkreis umfasst in der Regel eine Zwischenkreiskondensatorbatterie. Auf diese Weise kann in dem Zwischenkreis elektrische Energie zwischengespeichert werden.

Im realen Betrieb wandelt der Eingangs-Stromrichter die Wechselspannung in eine Gleichspannung um, welche noch Anteile einer Wechselspannung aufweist. Zur Reduktion dieser Wechselspannungsanteile in der Gleichspannung ist üblicherweise im Zweischenkreis ein Saugkreis vorgesehen.

Der im Zwischenkreis angeordnete Saugkreis ist auf eine bestimmte Frequenz abgestimmt. Üblicherweise ist der Saugkreis auf die doppelte Netzfrequenz abgestimmt. Das heißt, dass die Resonanzfrequenz des Saugkreises vorzugsweise bei der doppelten Netzfrequenz liegt. Auf diese Weise kann der Saugkreis den Wechselspannungsanteil mit der doppelten Netzfrequenz reduzieren.

Ein derartiges Stromrichter-System mit einem Eingangs-Stromrichter, einem Saugkreis aufweisenden Zwischenkreis und einem Ausgangs-Stromrichter kann auch in einer anderen technischen Einheit (anstatt in einem Schienenfahrzeug) vorgesehen sein.

Der Saugkreis umfasst einen oder mehrere Kondensatoren und eine Spule. Der zumindest eine Kondensator ist in Reihe zu der Spule geschaltet. Die Abstimmung des Saugkreises erfolgt über die Wahl einer geeigneten Kapazität für den/die Kondensator (en) .

Das Problem besteht darin, dass der zumindest eine Kondensator des Saugkreises altert. Das heißt, dass sich die elektrischen Eigenschaften - und damit auch die Kapazität - des Kondensators mit der Zeit ändern. Die Alterung des Kondensators hat einen Einfluss auf die Resonanzfrequenz des Saugkreises und damit auf die Abstimmung des Saugkreises.

Mit der Zeit entfernt sich die Resonanzfrequenz des Saugkreises von derjenigen Frequenz, auf welche der Saugkreis ursprünglich abgestimmt wurde, hier von der doppelten Netzfrequenz. Auf diese Weise entfernt sich die tatsächliche Abstimmung des Saugkreises von der ursprünglichen, vorgesehenen Abstimmung. Dies kann zu unerwünschten Signalverläufen der Zwischenkreisspannung führen. Sehr starke Schwingungen können die Folge sein, welche die komplexe und empfindliche Ansteuerung z.B. eines Asynchronmotors erschweren / stören können und/oder zum Ausfall des Systems führen können.

Derzeit ist in dem Stromrichter-System, insbesondere in dem Zwischenkreis, in der Regel ein Überspannungsbegrenzer vorgesehen. Bei einem verstimmten Saugkreis übersteigt die Zwischenkreisspannung einen kritischen Wert, sodass der Überspannungsbegrenzer aktiviert und damit das Stromrichter-System gesperrt bzw. deaktiviert wird.

Aus der Offenlegungsschrift DE 10 2005 004 697 A1 ist ein Verfahren zur Ermittlung eines Laststroms und Saugkreisstroms bei einem Vier-Quadrantensteller als Einspeisestromrichter eines Bahnfahrzeugs bekannt. Der Vier-Quadrantensteller besteht aus einer Gleichrichterschaltung, einer Zwischenkreiskapazität sowie einem Saugkreis mit einer Saugkreiskapazität und einer Saugkreisinduktivität, wobei in dem Saugkreis ein Saugkreisstrom fließt, der ein reiner Wechselstrom mit doppelter Netzfrequenz ist. Unter Verwendung eines Bandpasses, dessen Mittenfrequenz der Resonanzfrequenz des Saugkreises entspricht, wird ein in eine elektrische Last fließender Laststrom aus einem ermittelten Ausgangsstrom der Gleichrichterschaltung und dem Saugkreisstrom ermittelt. Als Bandpass kann als analoge elektronische Schaltung oder als zeitdiskrete Signalverarbeitung in einem Digitalrechner realisiert sein.

Eine Aufgabe der Erfindung ist es, ein verbessertes Verfahren zum Überprüfen einer Abstimmung eines in einem Zwischenkreis angeordneten Saugkreises anzugeben, welches im laufenden Betrieb des Stromrichtersystems angewandt werden kann. Insbesondere ist es eine Aufgabe, Abweichungen der Saugkreisabstimmung von der vorgesehenen Abstimmung des Saugkreises frühzeitig zu erkennen.

Die Aufgabe wird gelöst durch ein Verfahren gemäß Patentanspruch 1 zum Überwachen einer Abstimmung eines in einem Zwischenkreis eines Stromrichtersystems angeordneten Saugkreises, wobei der Zwischenkreis zwischen einen Eingangs-Stromrichter und einen Ausgangs-Stromrichter des Stromrichtersystems geschaltet ist. Ferner wird die Aufgabe durch eine Überwachungseinheit gemäß Patentanspruch 11 gelöst. Weiterbildungen sind in jeweiligen abhängigen Patentansprüchen angegeben.

Erfindungsgemäß wird dabei ein in den Zwischenkreis eingespeister Zwischenkreisstrom zeitabhängig ermittelt. Anhand des Zwischenkreisstroms wird zumindest derjenige doppelt-netzfrequente Zwischenkreisstrom, welcher bei einem vorgegebenen Betriebszustand des Stromrichtersystems fließt, ermittelt. Das heißt, dass zumindest derjenige doppelt-netzfrequente Zwischenkreisstrom, welcher bei einem vorgegebenen Betriebszustand des Stromrichtersystems fließt, anhand des in den Zwischenkreis eingespeisten Zwischenkreisstroms ermittelt wird.

Erfindungsgemäß wird zumindest derjenige doppelt-netzfrequente Zwischenkreisstrom, welcher bei einem vorgegebenen Betriebszustand fließt, und/oder eine aus diesem doppelt-netzfrequenten Zwischenkreisstrom abgeleitete Größe mit einer Referenz verglichen. Die Saugkreisabstimmung wird unter Verwendung eines Ergebnisses des Vergleichs überwacht.

Insbesondere kann anhand des Vergleichs festgestellt werden, ob und/oder in wieweit die tatsächliche Abstimmung des Saugkreises einer vorgesehenen Abstimmung entspricht.

Auf diese Weise kann eine Abweichung der Saugkreisabstimmung, d.h. eine Abweichung der tatsächlichen Abstimmung des Saugkreises von einer vorgesehenen Abstimmung, frühzeitig erkannt werden. Insbesondere kann eine Abweichung der Saugkreisabstimmung im laufenden Betrieb des Stromrichtersystems erkannt werden. Falls eine Abweichung der Saugkreisabstimmung erkannt wird, ist vorzugsweise das Stromrichtersystem weiter funktionsfähig.

Das Stromrichtersystem umfasst den Eingangs-Stromrichter, den Zwischenkreis und den Ausgangs-Stromrichter. Das Stromrichtersystem kann ein Stromrichtersystem für eine technische Einheit sein. Insbesondere kann das Stromrichtersystem ein Stromrichtersystem einer technischen Einheit sein.

Die technische Einheit kann eine stationäre Einheit oder eine mobile Einheit, insbesondere ein Fahrzeug, sein.

Zur Bestimmung des Betriebszustands wird erfindungsgemäß eine elektrische Leistung, welche in den Zwischenkreis eingespeist wird, ermittelt. Insbesondere kann die elektrische Leistung, welche in den Zwischenkreis eingespeist wird, ein Maß für den Betriebszustand sein.

Die elektrische Leistung, welche in den Zwischenkreis eingespeist wird, kann eine positive oder eine negative elektrische Leistung sein, welche vorzugsweise vom Eingangs-Stromrichter in den Zwischenkreis eingespeist wird.

Als negative elektrische Leistung, welche vom Eingangs-Stromrichter in den Zwischenkreis eingespeist wird, kann eine Leistung verstanden werden, die faktisch vom Zwischenkreis in den Eingangs-Stromrichter zurückgespeist wird.

Beispielsweise kann für den vorgegebenen Betriebszustand eine bestimmte elektrische Leistung, welche in den Zwischenkreis eingespeist wird, vorgegeben sein. Das heißt, dass der vorgegebene Betriebszustand durch eine bestimmte elektrische Leistung, welche in den Zwischenkreis eingespeist wird, charakterisiert sein kann.

Insbesondere kann zumindest derjenige doppelt-netzfrequente Zwischenkreisstrom, welcher zu demjenigen Zeitpunkt fließt, an dem die vorgegebene bestimmte elektrische Leistung in den Zwischenkreis eingespeist wird, und/oder eine aus diesem doppelt-netzfrequenten Zwischenkreisstrom abgeleitete Größe mit der Referenz verglichen werden.

In einer bevorzugten Ausgestaltung der Erfindung wird zumindest derjenige doppelt-netzfrequente Zwischenkreisstrom, welcher zu demjenigen Zeitpunkt fließt, an dem eine maximale elektrischen Leistung in den Zwischenkreis eingespeist wird, und/oder eine aus diesem doppelt-netzfrequenten Zwischenkreisstrom abgeleitete Größe mit dem Referenzstrom verglichen. Das heißt, dass als bestimmte elektrische Leistung eine maximale Leistung, welche in den Zwischenkreis eingespeist wird, vorgegeben sein kann.

Die maximale Leistung kann eine maximale Leistung innerhalb einer bestimmten Betriebszeit sein, beispielsweise innerhalb einer Betriebszeit von mehreren Stunden. Weiter kann die maximale Leistung vorliegen, wenn die in den Zwischenkreis eingespeiste elektrische Leistung einen vorgegebenen Wert übersteigt. Ferner kann die maximale Leistung vorliegen, wenn die in den Zwischenkreis eingespeiste elektrische Leistung einen vorgegebenen Anteil einer Nutzleistung des Stromrichtersystems, beispielsweise 90% der Nutzleitung des Stromrichtersystems, übersteigt.

Der doppelt-netzfrequente Zwischenkreisstrom kann, insbesondere zeitabhängig, zumindest für ein vorgegebenes Zeitintervall ermittelt werden. Außerdem kann die elektrische Leistung, welche in den Zwischenkreis eingespeist wird, insbesondere zeitabhängig, zumindest für das vorgegebene Zeitintervall ermittelt werden.

Zur Überwachung der Saugkreisabstimmung kann geprüft werden, ob innerhalb des vorgegebenen Zeitintervalls zwischen dem doppelt-netzfrequenten Zwischenkreisstrom oder einer daraus abgeleiteten Größe und der elektrischen Leistung eine vorgegebene Korrelation vorliegt. Insbesondere kann die Saugkreisabstimmung unter Verwendung eines Ergebnisses der Prüfung überwacht werden.

Beispielsweise kann eine tatsächliche Korrelation zwischen dem doppelt-netzfrequenten Zwischenkreisstrom oder einer daraus abgeleiteten Größe und der elektrischen Leistung ermittelt werden. In der Prüfung kann die tatsächliche Korrelation mit der vorgegebenen Korrelation verglichen werden. Anhand des Vergleichs kann festgestellt werden, ob und/oder in wieweit die tatsächliche Abstimmung des Saugkreises einer vorgesehenen Abstimmung entspricht.

Die vorgegebene Korrelation kann unter Verwendung von mehreren Referenzdaten derselben technischen Einheit und/oder einer oder mehrerer vergleichbarer technischen Einheiten ermittelt werden.

Die vorgegebene Korrelation kann beispielsweise unter Verwendung einer Trendanalyse und/oder einer Langzeitanalyse ermittelt werden. Weiter kann die vorgegebene Korrelation beispielsweise händisch und/oder automatisch, insbesondere mittels eines selbstlernenden Systems, ermitteln werden.

In einer vorteilhaften Ausgestaltung der Erfindung ist die Größe, welche aus zumindest demjenigen doppelt-netzfrequenten Zwischenkreisstrom, welcher bei dem vorgegebenen Betriebszustand fließt, abgeleitet wird, eine Impedanz des Zwischenkreises bei doppelter Netzfrequenz.

Insbesondere ist die Größe, welche aus zumindest demjenigen doppelt-netzfrequenten Zwischenkreisstrom, welcher bei dem vorgegebenen Betriebszustand fließt, abgeleitet wird, diejenige Impedanz des Zwischenkreises bei doppelter Netzfrequenz, welche bei dem vorgegebenen Betriebszustand wirkt, d. h. welche der Zwischenstromkreis bei dem vorgegebenen Betriebszustand aufweist.

Insbesondere kann zumindest diejenige Impedanz des Zwischenkreises bei doppelter Netzfrequenz, welche bei dem vorgegebenen Betriebszustand wirkt, mit der Referenz verglichen werden.

Vorzugsweise wird zumindest diejenige Impedanz des Zwischenkreises bei doppelter Netzfrequenz ermittelt, welche bei dem vorgegebenen Betriebszustand wirkt. Weiter kann die Impedanz des Zwischenkreises bei doppelter Netzfrequenz zeitabhängig ermittelt werden.

Zur Ermittlung der Impedanz des Zwischenkreises bei doppelter Netzfrequenz wird vorzugsweise eine doppelt-netzfrequente Zwischenkreisspannung ermittelt.

Zweckmäßigerweise ist diejenige Impedanz des Zwischenkreises bei doppelter Netzfrequenz, welche bei dem vorgegebenen Betriebszustand wirkt, ein Quotient aus derjenigen doppelt-netzfrequenten Zwischenkreisspannung, welche bei dem vorgegebenen Betriebszustand anliegt, und demjenigen doppelt-netzfrequenten Zwischenkreisstrom, welcher bei demselben Betriebszustand, insbesondere zu derselben Zeit, fließt.

Beispielsweise kann zur Überwachung der Saugkreisabstimmung geprüft werden, ob, insbesondere innerhalb des zuvor genannten vorgegebenen Zeitintervalls, zwischen der Impedanz des Zwischenkreises bei doppelter Netzfrequenz und der elektrischen Leistung eine vorgegebene Korrelation vorliegt.

Die Referenz ist vorzugsweise eine Größe dergleichen Art wie die zu vergleichende Größe, d. h. wie der zu vergleichende doppelt-netzfrequente Zwischenkreisstrom und/oder eine aus dem doppelt-netzfrequenten Zwischenkreisstrom abgeleitete zu vergleichende Größe.

Vorzugsweise ist die Referenz eine Referenz bei demselben vorgegebenen Betriebszustand, beispielsweise bei derselben bestimmten elektrischen Leistung. Die Referenz kann einen oder mehrere Werte und/oder Wertepaare umfassen.

Die Referenz kann beispielsweise ein Strom und/oder eine daraus abgeleitete Größe sein, welcher/welche unter Verwendung früherer doppelt-netzfrequenter Zwischenkreisströme desselben Stromrichtersystems ermittelt wurde/wird. Weiter kann der Referenzstrom ein Strom und/oder eine daraus abgeleitete Größe sein, welcher/welche unter Verwendung doppelt-netzfrequenter Zwischenkreisströme einer oder mehrerer vergleichbarer Stromrichtersysteme ermittelt wurde/wird.

Ein vergleichbares Stromrichtersystem ist vorzugsweise zumindest im Wesentlichen baugleich mit dem zuerst genannten Stromrichtersystem. Es ist zweckmäßig, wenn das vergleichbare Stromrichtersystem einen Zwischenkreisstromrichter dergleichen Art, einen Zwischenkreis dergleichen Art und einen Ausgangs-Stromrichter dergleichen Art wie das zuerst genannte Stromrichtersystem aufweist.

Falls zumindest derjenige doppelt-netzfrequente Zwischenkreisstrom, welcher bei einem vorgegebenen Betriebszustand fließt, und/oder eine aus diesem doppelt-netzfrequenten Zwischenkreisstrom abgeleitete Größe weniger als eine vorgegebenen Toleranz von der Referenz abweicht, kann festgestellt werden, dass die tatsächliche Abstimmung des Saugkreises einer vorgesehenen Abstimmung entspricht.

Falls zumindest derjenige doppelt-netzfrequente Zwischenkreisstrom, welcher bei einem vorgegebenen Betriebszustand fließt, und/oder eine aus diesem doppelt-netzfrequenten Zwischenkreisstrom abgeleitete Größe mehr als eine vorgegebene Toleranz von der Referenz abweicht, kann festgestellt werden, dass die tatsächliche Abstimmung des Saugkreises einer vorgesehenen Abstimmung nicht entspricht.

Weiter kann eine an den Zwischenkreis anliegende Zwischenkreisspannung zeitabhängig ermittelt werden. Zumindest eine Welligkeit derjenigen Zwischenkreisspannung, welche bei dem vorgegebenen Betriebszustand anliegt, kann ermittelt werden. Ferner kann zumindest die Welligkeit derjenigen Zwischenkreisspannung, welche bei dem vorgegebenen Betriebszustand anliegt, mit einer Referenzwelligkeit verglichen werden. Die Saugkreisabstimmung kann unter Verwendung des letztgenannten Vergleichs überwacht werden.

Insbesondere kann der letztgenannte Vergleich zur Überwachung der Saugkreisabstimmung herangezogen werden.

Auf diese Weise kann unter Verwendung des Vergleichs der Welligkeit mit der Referenzwelligkeit, insbesondere in Kombination mit dem zuvor genannten Vergleich des doppelt-netzfrequenten Zwischenkreisstroms und/oder der aus diesem doppelt-netzfrequenten Zwischenkreisstrom abgeleiteten Größe mit einer Referenz, ermittelt werden, ob und/oder in wieweit die tatsächliche Abstimmung des Saugkreises einer vorgesehenen Abstimmung entspricht.

Die Referenzwelligkeit kann unter Verwendung von Referenzdaten desselben Stromrichtersystems und/oder einer oder mehrerer vergleichbarer Stromrichtersysteme ermittelt werden.

Die Überwachung kann teilweise oder vollständig innerhalb der technischen Einheit stattfinden. Weiter kann die Überwachung teilweise oder vollständig außerhalb der technischen Einheit stattfinden.

Falls beispielsweise das Stromrichtersystem ein Stromrichtersystem eines Fahrzeugs ist, können die zur Überwachung nötigen Daten von dem Fahrzeug an eine landseitige Überwachungseinheit oder an einen landseitigen Teil einer Überwachungseinheit übermittelt werden.

Falls bei der Überwachung festgestellt wird, dass die tatsächliche Abstimmung des Saugkreises einer vorgesehenen Abstimmung nicht entspricht, kann das Stromrichtersystem, insbesondere der Saugkreis, gewartet werden. Falls bei der Überwachung festgestellt wird, dass die tatsächliche Abstimmung des Saugkreises einer vorgesehenen Abstimmung nicht entspricht, können außerdem zu- bzw. wegschaltbare Kondensatoren des Saugkreises zu- und/oder weggeschalten werden.

Die Erfindung und/oder die beschriebenen Weiterbildungen können - zumindest teilweise, wie auch im Gesamten - sowohl in Software als auch in Hardware, letztes beispielsweise unter Verwendung einer speziellen elektrischen Schaltung, realisiert werden.

Ferner ist eine Realisierung der Erfindung und/oder einer beschriebenen Weiterbildung, zumindest teilweise, wie auch im Gesamten, möglich durch ein computerlesbares Speichermedium, auf welchem ein Computerprogramm gespeichert ist, welches, wenn es auf einem Computer ausgeführt wird, die Erfindung oder deren Weiterbildung ausführt.

Auch können die Erfindung und/oder die beschriebenen Weiterbildungen, zumindest teilweise, wie auch im Gesamten, durch ein Computerprogrammerzeugnis realisiert sein, welches ein Speichermedium aufweist, auf welchem ein Computerprogramm gespeichert ist, welches, wenn es auf einem Computer ausgeführt wird, die Erfindung und/oder die Weiterbildungen ausführt.

Ferner ist die Erfindung gerichtet auf eine Überwachungseinheit zum Überwachen einer Abstimmung eines in einem Zwischenkreis eines Stromrichtersystems angeordneten Saugkreises, wobei der Zwischenkreis zwischen einen Eingangs-Stromrichter und einen Ausgangs-Stromrichter des Stromrichtersystems zwischengeschaltet ist.

Die Überwachungseinheit ist erfindungsgemäß dazu eingerichtet, anhand eines in den Zwischenkreis eingehenden Zwischenkreisstroms einen doppelt-netzfrequenten Zwischenkreisstrom zu ermitteln. Beispielsweise kann der doppelt-netzfrequente Zwischenkreisstrom unter Verwendung einer Fourieranalyse des in den Zwischenkreis eingehenden Zwischenkreisstroms ermittelt werden.

Die Überwachungseinheit ist weiter dazu eingerichtet, den Betriebszustand des Stromrichtersystems zu ermitteln. Insbesondere kann der Betriebszustand des Stromrichtersystems unter Verwendung des in den Zwischenkreis eingehenden Zwischenkreisstroms und/oder einer an den Zwischenkreis anliegenden Spannung ermittelt werden. Erfindungsgemäß wird zur Ermittlung des Betriebszustands des Stromrichtersystems die in den Zwischenkreis eingespeiste elektrische Leistung ermittelt.

Die Überwachungseinheit ist außerdem dazu eingerichtet, zumindest denjenigen doppelt-netzfrequenten Zwischenkreisstrom, welcher bei einem vorgegebenen Betriebszustand fließt, und/oder eine aus diesem doppelt-netzfrequenten Zwischenkreisstrom abgeleitete Größe mit einer Referenz zu vergleichen und die Saugkreisabstimmung unter Verwendung eines Ergebnisses des Vergleichs zu überwachen.

Insbesondere kann die Überwachungseinheit zur Durchführung des oben beschriebenen Verfahrens eingesetzt werden.

Weiter ist die Erfindung gerichtet auf ein System mit der zuvor genannten Überwachungseinheit und/oder einer seiner Weiterbildungen und einem Stromrichtersystem, welches einen Eingangs-Stromrichter, einen Ausgangs-Stromrichter und einen zwischen den Eingangs-Stromrichter und den Ausgangs-Stromrichter zwischengeschalteten Zwischenkreis umfasst, wobei in dem Zwischenkreis ein Saugkreis angeordnet ist.

Das Stromrichtersystem ist vorzugsweise das im Zusammenhang mit der Überwachungseinheit genannte Stromrichtersystem.

Das System mit der Überwachungseinheit und dem Stromrichtersystem kann zur Durchführung des oben beschriebenen Verfahrens eingesetzt werden. Insbesondere kann das Stromrichtersystem das im Zusammenhang mit dem Verfahren genannte Stromrichtersystem sein.

Das System kann außerdem ein Strommessgerät umfassen. Das Strommessgerät kann zum zeitabhängigen Messen eines in den Zwischenkreis eingehenden Zwischenkreisstroms eingerichtet sein. Weiter kann das Strommessgerät zum Messen eines anderen Stroms eingerichtet sein, unter Verwendung dessen der in den Zwischenkreis eingehende Zwischenkreisstrom ermittelt werden kann.

Weiter kann das System ein Spannungsmessgerät umfassen. Vorzugsweise ist das Spannungsmessgerät zum zeitabhängigen Messen einer an den Zwischenkreis anliegenden Spannung eingerichtet.

Vorzugsweise ist der Eingangs-Stromrichter ein Gleichrichter. Beispielsweise kann der Eingangs-Stromrichter ein Vierquadrantensteller sein. Der Eingangs-Stromrichter kann auch ein anderer Gleichrichter, beispielsweise ein Diodengleichrichter, sein.

Weiter ist es bevorzugt, wenn der Ausgangs-Stromrichter ein Wechselrichter ist. Beispielsweise kann der Ausgangs-Stromrichter ein Pulswechselrichter sein.

Die bisher gegebene Beschreibung vorteilhafter Ausgestaltungen der Erfindung enthält zahlreiche Merkmale, die in den einzelnen abhängigen Patentansprüchen teilweise zu mehreren zusammengefasst wiedergegeben sind. Diese Merkmale können jedoch zweckmäßigerweise auch einzeln betrachtet und zu sinnvollen weiteren Kombinationen zusammengefasst werden. Insbesondere sind diese Merkmale jeweils einzeln und in beliebiger geeigneter Kombination mit dem erfindungsgemäßen Verfahren, der erfindungsgemäßen Überwachungseinheit und dem erfindungsgemäßen System kombinierbar. So sind Verfahrensmerkmale auch als Eigenschaft der entsprechenden Vorrichtungseinheit gegenständlich formuliert zu sehen und umgekehrt.

Auch wenn in der Beschreibung bzw. in den Patentansprüchen einige Begriffe jeweils im Singular oder in Verbindung mit einem Zahlwort verwendet werden, soll der Umfang der Erfindung für diese Begriffe nicht auf den Singular oder das jeweilige Zahlwort eingeschränkt sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und mit einem beliebigen der Ansprüche kombiniert werden.

Es zeigen:
- FIG 1: ein Prinzip-Schaltbild eines Systems mit einem Stromrichtersystem und einer Überwachungseinheit,
- FIG 2: mehrere Diagramme, in welche die Drehzahl n des Motors aus FIG 1, die elektrische Leistung P_{Z}, welche in den Zwischenkreis aus FIG 1 eingespeist wird, der doppelt-netzfrequente Zwischenkreisstrom I_{Z,2f_{AC1}} und eine Welligkeit ω der Zwischenkreisspannung U_{Z} jeweils über der Zeit t aufgetragen sind.

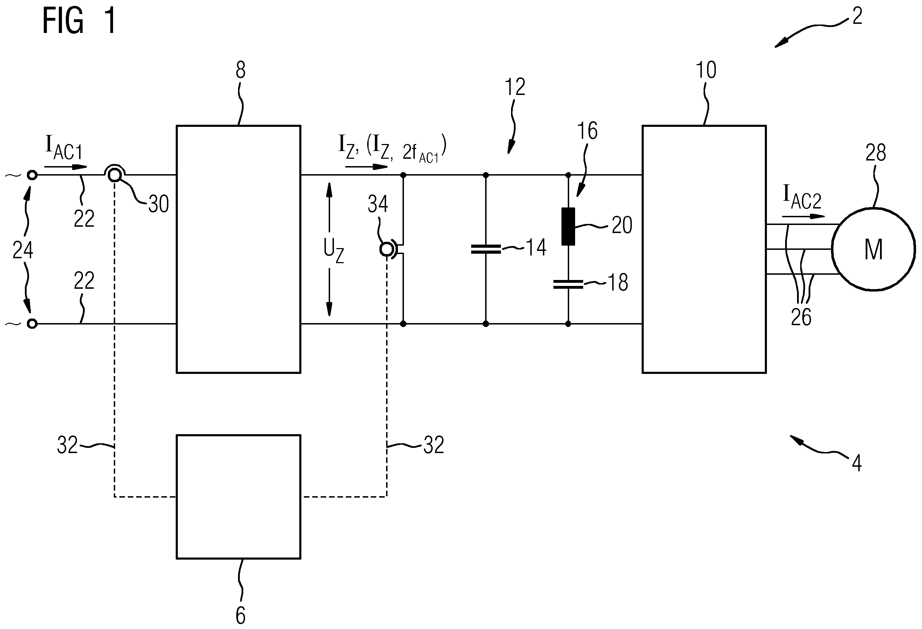

FIG 1 zeigt ein Prinzip-Schaltbild eines Systems 2, welches ein Stromrichtersystem 4 und eine Überwachungseinheit 6 aufweist.

Das Stromrichtersystem 4 umfasst einen Eingangs-Stromrichter 8, einen Ausgangs-Stromrichter 10 und einen zwischen den Eingangs-Stromrichter 8 und den Ausgangs-Stromrichter 10 zwischengeschalteten Zwischenkreis 12.

Der Zwischenkreis 12 umfasst eine Zwischenkreiskondensatorbatterie 14.

In dem Zwischenkreis ist ein Saugkreis 16 angeordnet. Der Saugkreis 16 ist zu der Zwischenkreiskondensatorbatterie 14 parallel geschaltet.

Der Saugkreis 16 umfasst einen Kondensator 18 und eine Spule 20, welche in Reihe zueinander geschaltet sind.

Das Stromrichtersystem 4 ist über Eingangsleitungen 22 mit einem Wechselspannungsnetz 24 verbunden. Das Wechselspannungsnetz 24 liefert eine Wechselspannung und einen Wechselstrom bei einer vorgegebenen Netzfrequenz f_{AC1}.

Das Stromrichtersystem 4 ist außerdem über Ausgangsleitungen 26 mit zumindest einem Motor 28 verbunden.

Der Eingangs-Stromrichter 8 ist ein Gleichrichter. In diesem Beispiel ist der Eingangs-Stromrichter 8 als ein Vierquadrantensteller ausgestaltet.

Der Ausgangs-Stromrichter 10 ist ein Wechselrichter. In diesem Beispiel ist der Ausgangs-Stromrichter 10 als ein Pulswechselrichter ausgestaltet.

Im Normalbetrieb des Stromrichtersystems 4 wird ein aus dem Wechselspannungsnetz 24 eingehender Wechselstrom I_{AC1} mittels des Eingangs-Stromrichters 8 in einen Zwischenkreisstrom I_{Z} umgewandelt. Der Zwischenkreisstrom I_{Z} wiederum wird mittels des Ausgangs-Stromrichters 10 in einen ausgehenden Wechselstrom I_{AC2} zum Betreiben des Motors 28 umgewandelt. In diesem Beispiel ist der ausgehende Wechselstrom I_{AC2} mehrphasig, hier dreiphasig, und wird als Dreiphasenwechselstrom bezeichnet.

Der Zwischenkreisstrom I_{Z} ist ein Gleichstrom, der Wechselstromanteile aufweisen kann. Insbesondere kann der Zwischenkreisstrom I_{Z} Wechselstromanteile mit der doppelten Netzfrequenz 2f_{AC1} aufweisen. Der Saugkreis 16 ist zur Reduktion des Wechselstromanteils bei der doppelten Netzfrequenz 2f_{AC1} vorgesehen. Hierzu ist eine Abstimmung des Saugkreises 16 auf die doppelte Netzfrequenz 2f_{AC1} vorgesehen. Das heißt, dass eine Resonanzfrequenz des Saugkreises 16 vorgesehen ist, die bei der doppelten Netzfrequenz 2f_{AC1} liegt.

Durch Alterung des Kondensators 18 des Saugkreises 16 kann die tatsächliche Abstimmung des Saugkreises 16 jedoch von der vorgesehenen Abstimmung abweichen.

Die Überwachungseinheit 6 ist zum Überwachen der Abstimmung des in dem Zwischenkreis 12 des Stromrichtersystems 4 angeordneten Saugkreises 16 vorgesehen und/oder eingerichtet.

Das System 2 umfasst ein Strommessgerät 30, welches über eine Datenverbindung 32 mit der Überwachungseinheit 6 verbunden ist. Die Datenverbindung 32 kann drahtgebunden und/oder drahtlos sein. Das Strommessgerät 30 ist als Stromwandler ausgeführt.

In diesem Beispiel ist das Strommessgerät 30 in einer der Eingangsleitungen 22 angeordnet. Das Strommessgerät 30 misst den aus dem Wechselspannungsnetz 24 eingehenden Wechselstrom I_{AC1} in Abhängigkeit der Zeit. Das gemessene Signal des eingehenden Wechselstroms I_{AC1} wird über die Datenverbindung 32 an die Überwachungseinheit 6 übertragen.

Die Wirkweise des Eingangs-Stromrichters 8 ist bekannt. Unter Verwendung des aus dem Wechselspannungsnetz 24 eingehenden Wechselstroms I_{AC1} wird, insbesondere von der Überwachungseinheit 6, der in den Zwischenkreis 12 eingehende Zwischenkreisstrom I_{Z} in Abhängigkeit der Zeit ermittelt. Das heißt, dass der ermittelte, in den Zwischenkreis 12 eingehende Zwischenkreisstrom I_{Z} ein virtueller bzw. modellierter Zwischenkreisstrom ist.

Prinzipiell könnte der in den Zwischenkreis 12 eingehende Zwischenkreisstrom I_{Z} auch direkt gemessen werden.

Unter Verwendung des in den Zwischenkreis 12 eingehenden Zwischenkreisstroms I_{Z} wird, insbesondere von der Überwachungseinheit 6, ein doppelt-netzfrequenter Zwischenkreisstrom I_{Z,2f_{AC1}} ermittelt. Insbesondere wird der doppelt-netzfrequente Zwischenkreisstrom I_{Z,2f_{AC1}} unter Verwendung einer Fourieranalyse des in den Zwischenkreis 12 eingehenden Zwischenkreisstroms I_{Z} ermittelt.

Weiter umfasst das System 2 ein Spannungsmessgerät 34, welches über eine Datenverbindung 32 mit der Überwachungseinheit 6 verbunden ist. Das Spannungsmessgerät 34 ist als Spannungswandler ausgeführt.

Das Spannungsmessgerät 34 ist im Zwischenkreis 12 angeordnet.

Das Spannungsmessgerät 34 misst eine an den Zwischenkreis 12 anliegende Spannung U_{Z} in Abhängigkeit der Zeit. Das gemessene Signal der Spannung U_{Z} wird über die Datenverbindung 32 an die Überwachungseinheit 6 übertragen.

Der Betriebszustand des Stromrichtersystems 4 wird, insbesondere von der Überwachungseinheit 6, ermittelt. Zur Ermittlung des Betriebszustands wird der in den Zwischenkreis 12 eingespeiste Zwischenkreisstrom I_{Z} und die an den Zwischenkreis 12 anliegende Spannung U_{Z} verwendet.

Insbesondere wird zur Bestimmung des Betriebszustands eine elektrische Leistung P_{Z}, welche in den Zwischenkreis 12 eingespeist wird, ermittelt. Die elektrische Leistung P_{Z}, welche in den Zwischenkreis 12 eingespeist wird, kann als Produkt des in den Zwischenkreis 12 eingehenden Zwischenkreisstroms I_{Z} mit der an den Zwischenkreis 12 anliegenden Spannung U_{Z} gebildet werden, kurz: P_{Z} = I_{Z}·U_{Z}.

Optional kann außerdem, insbesondere von der Überwachungseinheit 6, die Welligkeit ω der Zwischenkreisspannung U_{Z} ermittelt werden.

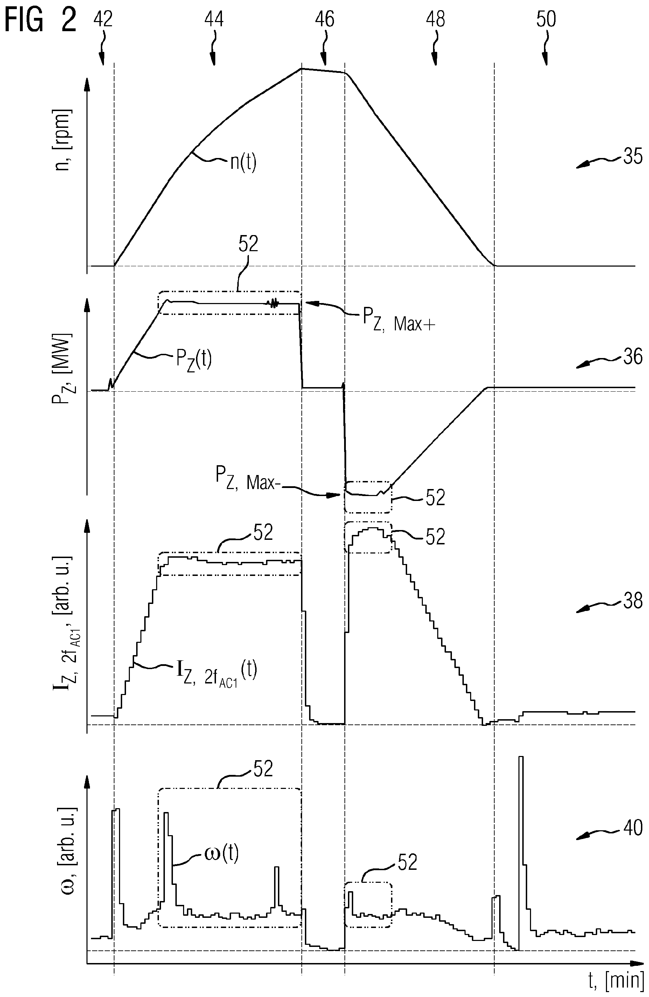

Der ermittelte doppelt-netzfrequente Zwischenkreisstrom I_{Z,2f_{AC1}} und die ermittelte elektrische Leistung P_{Z}, welche in den Zwischenkreis 12 eingespeist wird, sind in FIG 2 beispielshaft für das Stromrichtersystem 4 aus FIG 1 dargestellt.

FIG 2 zeigt mehrere Diagramme 35, 36, 38, 40 mit einer gemeinsamen x-Achse, auf welcher die Zeit t aufgetragen ist.

Im ersten, d. h. obersten, Diagramm 35 ist die Drehzahl n des Motors 28 aus FIG 1 über der Zeit t aufgetragen. Im zweiten Diagramm 36 ist die elektrische Leistung P_{Z}, welche in den Zwischenkreis 12 eingespeist wird, über der Zeit t aufgetragen. Im dritten Diagramm 38 ist der doppelt-netzfrequente Zwischenkreisstrom I_{Z,2f_{AC1}} über der Zeit t aufgetragen. Im vierten Diagramm ist die Welligkeit ω der Zwischenkreisspannung U_{Z} über der Zeit t aufgetragen.

Die x-Achse (Zeit-Achse) kann in mehrere Bereiche eingeteilt werden. Im ersten Bereich 42 steht der Motor still, die Drehzahl n beträgt Null.

Im zweiten Bereich 44 steigt die Drehzahl n kontinuierlich an. Damit ist der zweite Bereich 44 ein Beschleunigungsbereich. Im zweiten Bereich 44 steigt die elektrische Leistung P_{Z}, welche in den Zwischenkreis 12 eingespeist wird, zunächst an und liegt dann im Wesentlichen auf einem maximalen positiven Niveau bei P_{Max+}.

Im dritten Bereich 46 bleibt die Drehzahl n annähernd konstant. Außerdem ist der dritte Bereich 46 gekennzeichnet durch eine minimale elektrische Leistung P_{Z}, welche in den Zwischenkreis eingespeist wird. In diesem dritten Bereich 46 ist der Motor 28 im Leerlauf.

Im vierten Bereich 48 wird die Drehzahl n des Motors 28 reduziert. Das heißt, dass der Motor 28 gebremst wird. In diesem vierten Bereich 48 wird die elektrische Leistung P_{Z}, welche in den Zwischenkreis 12 eingespeist wird, negativ. Das heißt, dass faktisch elektrische Leistung zurück in das Wechselspannungsnetz gespeist wird. Im vierten Bereich 48 liegt die elektrische Leistung P_{Z}, welche in den Zwischenkreis 12 eingespeist wird, im Wesentlichen auf einem maximalen negativen Niveau bei P_{Max-} bevor sie (noch im vierten Bereich 48) auf das minimale Niveau nahe Null absinkt.

Im fünften Bereich 50 steht der Motor wieder still, die Drehzahl n beträgt Null. Im fünften Bereich 50 verbleibt die elektrische Leistung P_{Z}, welche in den Zwischenkreis 12 eingespeist wird, auf dem minimalen Niveau nahe Null.

Die Überwachungseinheit 6 aus FIG 1 ist dazu eingerichtet, zumindest denjenigen doppelt-netzfrequenten Zwischenkreisstrom I_{Z,2f_{AC1}}, welcher bei einem vorgegebenen Betriebszustand fließt, und/oder eine aus diesem doppelt-netzfrequenten Zwischenkreisstrom I_{Z,2f_{AC1}} abgeleitete Größe mit einer Referenz zu vergleichen. Die Saugkreisabstimmung wird unter Verwendung des Vergleichs überwacht.

Im Folgenden werden verschiedene Fälle beschrieben, welche alternativ zueinander und/oder in Kombination ausgeführt werden können:

### Fall 1:

Derjenige doppelt-netzfrequente Zwischenkreisstrom I_{Z,2f_{AC1}}, welcher bei einem vorgegebenen Betriebszustand fließt, wird mit der Referenz verglichen.

Für den vorgegebenen Betriebszustand wird eine bestimmte elektrische Leistung P_{Z}, welche in den Zwischenkreis 12 eingespeist wird, vorgegeben. Als bestimmte elektrische Leistung P_{Z}, welche in den Zwischenkreis 12 eingespeist wird, wird in diesem Beispiel das maximale positive Leistungsniveau P_{Max+} und/oder das maximale negative Leistungsniveau P_{Max-} vorgegeben.

Der vorgegebene Betriebszustand liegt vor, wenn die elektrische Leistung P_{Z}, welche in den Zwischenkreis 12 eingespeist wird, zumindest im Wesentlichen bei dem maximalen positiven Leistungsniveau P_{Max+} oder zumindest im Wesentlichen bei dem maximalen negativen Leistungsniveau P_{Max-} liegt. Zumindest im Wesentlichen bedeutet hier, dass eine Unterschreitung von maximal 5%, insbesondere von maximal 3%, zulässig ist. (Dies gilt auch für Fall 2.)

Das heißt, dass im Fall 1 derjenige doppelt-netzfrequente Zwischenkreisstrom I_{Z,2f_{AC1}}, welcher zu demjenigen Zeitpunkt fließt, an dem zumindest im Wesentlichen eine maximale positive oder negative elektrische Leistung P_{Max+}, P_{Max-} in den Zwischenkreis eingespeist wird, mit der Referenz verglichen wird.

Im Diagramm 36 in FIG 2 sind die Bereiche, in denen die elektrische Leistung P_{Z}, welche in den Zwischenkreis 12 eingespeist wird, zumindest im Wesentlichen bei dem maximalen positiven Leistungsniveau P_{Max+} oder zumindest im Wesentlichen bei dem maximalen negativen Leistungsniveau P_{Max-} liegt, mittels einer gestrichelten Linie eingekreist (eingekreiste Bereiche 52).

Analog sind im Diagramm 38 in FIG 2 die Bereiche zu denjenigen Zeitpunkten, an denen zumindest im Wesentlichen eine maximale positive oder negative elektrische Leistung P-_{Max+}, P_{Max-} in den Zwischenkreis eingespeist wird, eingekreist (eingekreiste Bereiche 52).

Im Diagramm 38 in FIG 2 ist deutlich zu sehen, dass in den eingekreisten Bereichen 52 (- also zu denjenigen Zeitpunkten, an denen zumindest im Wesentlichen eine maximale positive oder negative elektrische Leistung P_{Max+}, P_{Max-} in den Zwischenkreis eingespeist wird -) der doppelt-netzfrequente Zwischenkreisstrom I_{Z,2f_{AC1}} Maxima aufweist.

Für jeden der eingekreisten Bereiche 52 wird der doppelt-netzfrequente Zwischenkreisstrom I_{Z,2f_{AC1}} mit der Referenz verglichen. Dazu kann beispielsweise für jeden Bereich ein Mittelwert des jeweiligen doppelt-netzfrequenten Zwischenkreisstroms I_{Z,2f_{AC1}} gebildet werden, welcher mit der Referenz verglichen wird.

Die Referenz umfasst vorzugsweise mehrere Wertepaare. Die Wertepaare der Referenz geben beispielsweise ideale doppelt-netzfrequente Zwischenkreisströme bei verschiedenen elektrischen Leistungen an. Vorzugsweise wird zum Vergleich das passende Wertepaar der Referenz genutzt oder es kann eine Interpolation zwischen zwei Wertepaaren stattfinden.

Die Referenz kann auch nur einen einzigen Wert aufweisen.

Die Saugkreisabstimmung wird unter Verwendung des Vergleichs überwacht.

Zusätzlich kann zur Überwachung der Saugkreisabstimmung die Welligkeit ω derjenigen Zwischenkreisspannung U_{Z}, welche bei dem vorgegebenen Betriebszustand anliegt, herangezogen werden.

Im Diagramm 40 ist die Welligkeit ω der Zwischenkreisspannung U_{Z} zeitabhängig aufgetragen. Die Bereiche, in denen der vorgegebene Betriebszustand vorliegt, sind wieder eingekreist (eingekreiste Bereiche 52 im Diagramm 40). Das heißt, innerhalb der eingekreisten Bereiche 52 ist die Welligkeit ω derjenigen Zwischenkreisspannung U_{Z}, welche bei dem vorgegebenen Betriebszustand anliegt, aufgetragen.

Beispielsweise können die Maxima der Welligkeit ω innerhalb der eingekreisten Bereiche 52 im Diagramm 40 jeweils mit einer Referenzwelligkeit, beispielsweise mit einer maximalen zulässigen Welligkeit, verglichen werden. Dieser Vergleich kann - insbesondere zusätzlich zu dem Vergleich des oben genannten doppelt-netzfrequenten Zwischenkreisstroms I_{Z,2f_{AC1}} mit der Referenz - zur Überwachung der Saugkreisabstimmung genutzt werden.

### Fall 2:

Eine aus demjenigen doppelt-netzfrequenten Zwischenkreisstrom I_{Z,2f_{AC1}}, welcher bei einem vorgegebenen Betriebszustand fließt, abgeleitete Größe wird mit der Referenz verglichen.

Die Größe, welche aus demjenigen doppelt-netzfrequenten Zwischenkreisstrom, welcher bei dem vorgegebenen Betriebszustand fließt, abgeleitet wird, ist in diesem Beispiel eine Impedanz Z_{2f_{AC1}} des Zwischenkreises 12 bei doppelter Netzfrequenz 2f_{AC1}, welche Impedanz Z_{2f_{AC1}} insbesondere bei dem vorgegebenen Betriebszustand wirkt.

Zur Bestimmung der Impedanz Z_{2f_{AC1}} wird zunächst, insbesondere von der Überwachungseinheit 6, anhand der Zwischenkreisspannung U_{Z} eine doppelt-netzfrequente Zwischenkreisspannung U_{Z,2f_{AC1}} ermittelt.

Insbesondere wird die doppelt-netzfrequente Zwischenkreisspannung U_{Z,2f_{AC1}} unter Verwendung einer Fourieranalyse der an den Zwischenkreis 12 anliegenden Zwischenkreisspannung U_{Z} ermittelt.

Zweckmäßigerweise ist diejenige Impedanz Z_{2f_{AC}}, des Zwischenkreises 12 bei doppelter Netzfrequenz 2f_{AC1}, welche bei dem vorgegebenen Betriebszustand (hier zumindest im Wesentlichen bei dem maximalen positiven oder negativen Leistungsniveau P_{Max+} oder P_{Max-} von P_{Z}) wirkt, ein Quotient aus derjenigen doppelt-netzfrequenten Zwischenkreisspannung U_{Z,2f_{AC,1}}, welche bei dem vorgegebenen Betriebszustand anliegt, und demjenigen doppelt-netzfrequenten Zwischenkreisstrom I_{Z,2f_{AC1}}, welcher bei demselben Betriebszustand - insbesondere zu derselben Zeit - fließt.

Das heißt, dass in diesem Beispiel, für diejenigen Zeiten, bei denen die eingekreisten Bereiche 52 in FIG 2 liegen, die jeweiligen Impedanzen Z_{2f_{AC1}} des Zwischenkreises 12 bei doppelter Netzfrequenz 2f_{AC1} gebildet werden. Die Impedanz Z_{2f_{AC1}} des Zwischenkreises 12 bei doppelter Netzfrequenz 2f_{AC1} für jeden der eingekreisten Bereiche 52 kann jeweils entweder zeitabhängig oder ein einziger (Mittel-)Wert sein.

Für jeden der eingekreisten Bereiche 52 wird die Impedanz Z_{2f_{AC1}} des Zwischenkreises 12 bei doppelter Netzfrequenz 2f_{AC1} mit der Referenz verglichen.

Beispielsweise entspricht die tatsächliche Abstimmung des Saugkreises 16 der vorgegebenen Abstimmung, wenn die Impedanz Z_{2f_{AC1}} des Zwischenkreises 12 bei doppelter Netzfrequenz 2f_{AC1} (bei dem vorgegebenen Betriebszustand) bei maximal 20 mΩ liegt.

Wenn die Impedanz Z_{2f_{AC1}} des Zwischenkreises 12 bei doppelter Netzfrequenz 2f_{AC1} (bei dem vorgegebenen Betriebszustand) bei mehr als 20 mΩ liegt, entspricht die tatsächliche Abstimmung des Saugkreises 16 der vorgegebenen Abstimmung nicht mehr.

Liegt die Impedanz Z_{2fAC1} des Zwischenkreises 12 bei doppelter Netzfrequenz 2f_{AC1} (bei dem vorgegebenen Betriebszustand) über 20 mΩ und unterhalb 100 mΩ, so kann das Stromrichtersystem 4 weiter betrieben werden. Ein Betreiben des Motors 28 kann auf diese Weise gewährleistet werden.

Liegt die Impedanz Z_{2fAC1} des Zwischenkreises 12 bei doppelter Netzfrequenz 2f_{AC1} (bei dem vorgegebenen Betriebszustand) über 100 mΩ, so gilt der Saugkreis 16 als verstimmt. Vorzugsweise erfolgt in diesem Fall eine Wartung des Stromrichtersystems 4, bei der der Saugkreis 16 neu abgestimmt wird, insbesondere indem zu- und/oder wegschaltbare Kondensatoren des Saugkreises zu- und/oder weggeschaltet werden (nicht gezeigt).

### Fall 3:

Es werden nicht nur die in FIG 2 eingekreisten Bereiche 52 (bei dem vorgegebenen Betriebszustand) ausgewertet, sondern es wird der doppelt-netzfrequente Zwischenkreisstrom I_{Z,2f_{AC1}} über die Zeit t eines vorgegebenen Zeitintervalls und/oder eine aus diesem doppelt-netzfrequenten Zwischenkreisstrom I_{Z,2f_{AC1}} abgeleitete Größe mit einer Referenz verglichen.

Als Zeitintervall wird in diesem Beispiel das in FIG 2 dargestellte Zeitintervall gewählt.

Zur Überwachung der Saugkreisabstimmung wird, insbesondere von der Überwachungseinheit 6, geprüft, ob zwischen dem doppelt-netzfrequenten Zwischenkreisstrom I_{Z,2f_{AC1}} oder einer daraus abgeleiteten Größe - zum Beispiel der Impedanz Z_{2fAC1} des Zwischenkreises 12 bei doppelter Netzfrequenz 2f_{AC1} - und der elektrischen Leistung P_{Z}, welche in den Zwischenkreis 12 eingespeist wird, eine vorgegebene Korrelation vorliegt.

Beispielsweise können die zeitabhängigen Werte des doppelt-netzfrequenten Zwischenkreisstroms I_{Z,2f_{AC1}} oder der daraus abgeleiteten Größe in Abhängigkeit der elektrischen Leistung P_{Z}, welche in den Zwischenkreis 12 eingespeist wird, dargestellt werden. Dann kann geprüft werden, ob die Werte des doppelt-netzfrequenten Zwischenkreisstroms I_{Z,2f_{AC1}} oder der daraus abgeleiteten Größe in Abhängigkeit der elektrischen Leistung P_{Z} der vorgegebenen Korrelation folgen.

Weiter kann beispielsweise eine tatsächliche Korrelation zwischen den Werten des doppelt-netzfrequenten Zwischenkreisstroms I_{Z,2f_{AC1}} (oder der daraus abgeleiteten Größe) und der elektrischen Leistung P_{Z} ermittelt werden, welche dann mit der vorgegebenen Korrelation verglichen wird.

Die Saugkreisabstimmung kann unter Verwendung des jeweiligen Vergleichs überwacht werden.

In jedem der vorgeschlagenen Fälle kann die Saugkreisabstimmung im laufenden Betrieb des Stromrichtersystems 4 überwacht werden. Insbesondere muss die Versorgung des Motors 28 nicht unterbrochen werden. Außerdem kann frühzeitig erkannt werden, wenn die tatsächliche Abstimmung des Saugkreises 16 von der vorgegebenen Abstimmung abweicht.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Überwachen einer Abstimmung eines in einem Zwischenkreis (12) eines Stromrichtersystems (4) angeordneten Saugkreises (16), wobei der Zwischenkreis (12) zwischen einen Eingangs-Stromrichter (8) und einen Ausgangs-Stromrichter (10) des Stromrichtersystems (4) geschaltet ist,
bei dem
- ein in den Zwischenkreis (12) eingespeister Zwischenkreisstrom (I_{Z}) zeitabhängig ermittelt wird,
- anhand des Zwischenkreisstroms (I_{Z}) zumindest derjenige doppelt-netzfrequente Zwischenkreisstrom (I_{Z,2f_{AC1}}), welcher bei einem vorgegebenen Betriebszustand des Stromrichtersystems (4) fließt, ermittelt wird,
- der doppelt-netzfrequente Zwischenkreisstrom (I_{Z,2f_{AC1}}) und/oder eine aus diesem abgeleitete Größe mit einer Referenz verglichen wird, und
- die Saugkreisabstimmung unter Verwendung eines Ergebnisses des Vergleichs überwacht wird,
**dadurch gekennzeichnet, dass**
zur Bestimmung des vorgegebenen Betriebszustands eine elektrische Leistung (P_{z}), welche in den Zwischenkreis (12) eingespeist wird, ermittelt wird.

2. Verfahren nach Anspruch 1,
**dadurch gekennzeichnet, dass**
die elektrische Leistung (P_{Z}), welche in den Zwischenkreis (12) eingespeist wird, eine positive oder negative elektrische Leistung (P_{Z}) ist, die vom Eingangs-Stromrichter (8) in den Zwischenkreis (12) eingespeist wird.

3. Verfahren nach einem der vorhergehenden Ansprüche,
**dadurch gekennzeichnet, dass**
für den vorgegebenen Betriebszustand eine bestimmte elektrische Leistung (P_{Z}), welche in den Zwischenkreis (12) eingespeist wird, vorgegeben ist,
sodass zumindest derjenige doppelt-netzfrequente Zwischenkreisstrom (I_{Z,2f_{AC1}}), welcher zu demjenigen Zeitpunkt fließt, an dem die vorgegebene bestimmte elektrischen Leistung (P_{Z}) in den Zwischenkreis (12) eingespeist wird, und/oder eine aus diesem doppelt-netzfrequenten Zwischenkreisstrom (I_{Z,2f_{AC1}}) abgeleitete Größe mit der Referenz verglichen wird.

4. Verfahren nach Anspruch 3,
**dadurch gekennzeichnet, dass**
zumindest derjenige doppelt-netzfrequente Zwischenkreisstrom (I_{Z,2f_{AC1}}), welcher zu demjenigen Zeitpunkt fließt, an dem eine maximale elektrischen Leistung (P_{Max+}, P_{Max-}) in den Zwischenkreis (12) eingespeist wird, und/oder eine aus diesem doppelt-netzfrequenten Zwischenkreisstrom (I_{Z,2f_{AC1}}) abgeleitete Größe mit der Referenz verglichen wird.

5. Verfahren nach einem der Ansprüche 1 bis 4,
**dadurch gekennzeichnet, dass**
der doppelt-netzfrequente Zwischenkreisstrom (I_{Z,2f_{AC1}}) zumindest für ein vorgegebenes Zeitintervall ermittelt wird, die elektrische Leistung (P_{Z}), welche in den Zwischenkreis (12) eingespeist wird, zumindest für das vorgegebene Zeitintervall ermittelt wird, und
zur Überwachung der Saugkreisabstimmung geprüft wird, ob innerhalb des vorgegebenen Zeitintervalls zwischen dem doppelt-netzfrequenten Zwischenkreisstrom (I_{Z,2f_{AC1}}) oder einer daraus abgeleiteten Größe und der elektrischen Leistung (P_{Z}) eine vorgegebene Korrelation vorliegt.

6. Verfahren nach einem der vorhergehenden Ansprüche,
**dadurch gekennzeichnet, dass**
die Größe, welche aus zumindest demjenigen doppelt-netzfrequenten Zwischenkreisstrom (I_{Z,2f_{AC1}}), welcher bei dem vorgegebenen Betriebszustand fließt, abgeleitet wird, eine Impedanz (Z_{2f_{AC1}}) des Zwischenkreises (12) bei doppelter Netzfrequenz (2f_{AC1}) ist.

7. Verfahren nach einem der vorhergehenden Ansprüche,
**dadurch gekennzeichnet, dass**
die Referenz ein Strom und/oder eine daraus abgeleitete Größe ist,
- welche(r) unter Verwendung früherer doppelt-netzfrequenter Zwischenkreisströme (I_{Z,2f_{AC1}}) desselben Stromrichtersystems (4) ermittelt wurde/wird und/oder
- welche(r) unter Verwendung doppelt-netzfrequenter Zwischenkreisströme (I_{Z,2f_{AC1}}) eines oder mehrerer vergleichbarer Stromrichtersysteme ermittelt wurde/wird.

8. Verfahren nach einem der vorhergehenden Ansprüche,
**dadurch gekennzeichnet, dass**,
falls zumindest derjenige doppelt-netzfrequente Zwischenkreisstrom (I_{Z,2f_{AC1}}), welcher bei einem vorgegebenen Betriebszustand fließt, und/oder eine aus diesem doppelt-netzfrequenten Zwischenkreisstrom (I_{Z,2f_{AC1}}) abgeleitete Größe mehr als eine vorgegebene Toleranz von der Referenz abweicht, festgestellt wird, dass die tatsächliche Abstimmung des Saugkreises (16) einer vorgesehenen Abstimmung nicht entspricht.

9. Verfahren nach einem der vorhergehenden Ansprüche,
**dadurch gekennzeichnet, dass**
eine an den Zwischenkreis (12) anliegende Zwischenkreisspannung (U_{Z}) zeitabhängig ermittelt wird,
eine Welligkeit (ω) zumindest derjenigen Zwischenkreisspannung (U_{Z}), welche bei dem vorgegebenen Betriebszustand anliegt, ermittelt und mit einer Referenzwelligkeit verglichen wird,
und die Saugkreisabstimmung unter Verwendung des letztgenannten Vergleichs überwacht wird.

10. Verfahren nach einem der vorhergehenden Ansprüche,
**dadurch gekennzeichnet, dass**,
falls bei der Überwachung festgestellt wird, dass die tatsächliche Abstimmung des Saugkreises (16) einer vorgesehenen Abstimmung nicht entspricht,
- das Stromrichtersystem (4), insbesondere der Saugkreis (16), gewartet wird und/oder
- zu- bzw. wegschaltbare Kondensatoren des Saugkreises (16) zu- und/oder weggeschalten werden.

11. Überwachungseinheit (6) zum Überwachen einer Abstimmung eines in einem Zwischenkreis (12) eines Stromrichtersystems (4) angeordneten Saugkreises (16), wobei der Zwischenkreis (12) zwischen einen Eingangs-Stromrichter (8) und einen Ausgangs-Stromrichter (10) des Stromrichtersystems (4) zwischengeschaltet ist,
wobei die Überwachungseinheit (6) dazu eingerichtet ist,
- unter Verwendung eines in den Zwischenkreis (12) eingehenden Zwischenkreisstroms (I_{Z}) einen doppelt-netzfrequenten Zwischenkreisstrom (I_{Z,2f_{AC1}}) zu ermitteln,
- einen hierzu vorgegebenen Betriebszustand des Stromrichtersystems (4) zu bestimmen,
- den doppelt-netzfrequenten Zwischenkreisstrom (I_{Z,2f_{AC1}}) und/oder eine aus diesem abgeleitete Größe mit einer Referenz zu vergleichen, und
- die Saugkreisabstimmung unter Verwendung eines Ergebnisses des Vergleichs zu überwachen,
**dadurch gekennzeichnet, dass**
die Überwachungseinheit weiterhin dazu eingerichtet ist, dass zur Bestimmung des vorgegebenen Betriebszustands eine elektrische Leistung (Pz), welche in den Zwischenkreis (12) eingespeist wird, ermittelt wird.

12. System (2) mit der Überwachungseinheit (6) nach Anspruch 11 und einem Stromrichtersystem (4), welches einen Eingangs-Stromrichter (8), einen Ausgangs-Stromrichter (10) und einen zwischen den Eingangs-Stromrichter (8) und den Ausgangs-Stromrichter (10) zwischengeschalteten Zwischenkreis (12) umfasst, wobei in dem Zwischenkreis (12) ein Saugkreis (16) angeordnet ist.

13. System (2) nach Anspruch 12,
**dadurch gekennzeichnet, dass**
der Eingangs-Stromrichter (8) ein Gleichrichter, insbesondere ein Vierquadrantensteller, ist.

14. System (2) nach Anspruch 12 oder 13,
**dadurch gekennzeichnet, dass**
der Ausgangs-Stromrichter (10) ein Wechselrichter, insbesondere ein Pulswechselrichter, ist.

## Claims

1. Method for monitoring an adjustment of an absorption circuit (16) arranged in a DC link circuit (12) of a converter system (4), wherein the DC link circuit (12) is connected between an input converter (8) and an output converter (10) of the converter system (4),
in which
- a DC link circuit current (I_{z}) fed into the DC link circuit (12) is ascertained in a time-dependent manner,
- based on the DC link circuit current (I_{z}), at least the double mains frequency DC link circuit current (*I*_{*Z,*2*f*_{*AC*1}}) which flows during a predefined operating state of the current converter system (4) is ascertained,
- the double mains frequency DC link circuit current (*I*_{*Z,*2*f*_{*AC*1}}) and/or a variable derived from this is compared with a reference, and
- the absorption circuit adjustment is monitored using a result of the comparison,
**characterised in that**
an electrical power (P_{z}) which is fed into the DC link circuit (12) is ascertained for determining the predefined operating state.

2. Method according to claim 1,
**characterised in that**
the electrical power (P_{z}) which is fed into the DC link circuit (12) is a positive or negative electrical power (P_{z}) which is fed from the input converter (8) into the DC link circuit (12).

3. Method according to one of the preceding claims,
**characterised in that**
a specific electrical power (P_{z}) which is fed into the DC link circuit (12) is predefined for the predefined operating state, in order that at least the double mains frequency DC link circuit current (*I*_{*Z,*2*f*_{*AC*1}}) which flows at the time instant when the predefined specific electrical power (P_{z}) is fed into the DC link circuit (12) and/or a variable derived from this double mains frequency DC link circuit current (*I*_{*Z,*2*f*_{*AC*1}}) is compared with the reference.

4. Method according to claim 3,
**characterised in that**
at least the double mains frequency DC link circuit current (*I*_{*Z,*2*f*_{*AC*1}}) which flows at the time instant when the maximum electrical power (P_{Max+,} P_{Max-}) is fed into the DC link circuit (12) and/or a variable derived from this double mains frequency DC link circuit current (*I*_{*Z,*2*f*_{*AC*1}}) is compared with the reference.

5. Method according to one of claims 1 to 4,
**characterised in that**
the double mains frequency DC link circuit current (*I*_{*Z,*2*f*_{*AC*1}}) is ascertained for at least a predefined time interval,
the electrical power (P_{z}) which is fed into the DC link circuit (12) is ascertained at least for the predefined time interval, and
for monitoring the absorption circuit adjustment, it is checked whether, within the predefined time interval, a predefined correlation is present between the double mains frequency DC link circuit current (*I*_{*Z,*2*f*_{*AC*1}}) or a variable derived therefrom and the electrical power (P_{z}).

6. Method according to one of the preceding claims,
**characterised in that**
the variable which is derived at least from the double mains frequency DC link circuit current (*I*_{*Z,*2*f*_{*AC*1}}) which flows during the predefined operating state is an impedance (*I*_{*Z,*2*f*_{*AC*1}}) of the DC link circuit (12) at double mains frequency (2f_{AC1}).

7. Method according to one of the preceding claims,
**characterised in that**
the reference is a current and/or a variable derived therefrom
- which was/is ascertained using previous double mains frequency DC link circuit currents (*I*_{*Z,*2*f*_{*AC*1}}) of the same converter system (4) and/or
- which was/is ascertained using double mains frequency DC link circuit currents (*I*_{*Z,*2*f*_{*AC*1}}) of one or a plurality of comparable converter systems.

8. Method according to one of the preceding claims,
**characterised in that**
if at least the double mains frequency DC link circuit current (*I*_{*Z,*2*f*_{*AC*1}}) which flows during a predefined operating state and/or a variable derived from this double mains frequency DC link circuit current (*I*_{*Z,*2*f*_{*AC*1}}) deviates from the reference by more than a predefined tolerance, it is established that the actual adjustment of the absorption circuit (16) does not correspond to an intended adjustment.

9. Method according to one of the preceding claims,
**characterised in that**
a DC link circuit voltage (U_{z}) present at the DC link circuit (12) is ascertained in a time-dependent manner,
a ripple (ω) of at least the DC link circuit voltage (U_{z}) which is present during the predefined operating state is ascertained and is compared with a reference ripple,
and the absorption circuit adjustment is monitored using the latter comparison.

10. Method according to one of the preceding claims,
**characterised in that**,
if it is established during the monitoring that the actual adjustment of the absorption circuit (16) does not correspond to an intended adjustment,
- the converter system (4), in particular the absorption circuit (16), is serviced and/or
- connectable or disconnectable capacitors of the absorption circuit (16) are connected and/or disconnected.

11. Monitoring unit (6) for monitoring an adjustment of an absorption circuit (16) arranged in a DC link circuit (12) of a converter system (4), wherein the DC link circuit (12) is connected between an input converter (8) and an output converter (10) of the converter system (4),
wherein
the monitoring unit (6) is configured
- to ascertain a double mains frequency DC link circuit current (*I*_{*Z,*2*f*_{*AC*1}}) using a DC link circuit current (I_{z}) entering the DC link circuit (12),
- to determine an operating state of the converter system (4) predefined in this context,
- to compare the double mains frequency DC link circuit current (*I*_{*Z,*2*f*_{*AC*1}}) and/or a variable derived therefrom with a reference, and
- to monitor the absorption circuit adjustment using a result of the comparison,
**characterised in that**
the monitoring unit is furthermore configured such that an electrical power (P_{z}), which is fed into the DC link circuit (12), is ascertained for determining the predefined operating state.

12. System (2) with the monitoring unit (6) according to claim 11 and a converter system (4) which comprises an input converter (8), an output converter (10) and a DC link circuit (12) connected between the input converter (8) and the output converter (10), wherein an absorption circuit (16) is arranged in the DC link circuit (12).

13. System (2) according to claim 12,
**characterised in that**
the input converter (8) is a rectifier, in particular a four-quadrant converter.

14. System (2) according to claim 12 or 13,
**characterised in that**
the output converter (10) is an inverter, in particular a pulse-controlled inverter.

## Revendications

1. Procédé de contrôle de l'accord d'un circuit (16) d'absorption monté dans un circuit (12) intermédiaire d'un système (4) de convertisseur, dans lequel le circuit (12) intermédiaire est monté entre un convertisseur (8) d'entrée et un convertisseur (10) de sortie du système (4) de convertisseur,
dans lequel
- on établit en fonction du temps un courant (I_{Z}) de circuit intermédiaire injecté dans le circuit (12) intermédiaire,
- à l'aide du courant (I_{Z}) de circuit intermédiaire, on établit au moins le courant (I_{Z,2f_{AC1}}) de circuit intermédiaire à la fréquence du réseau doublée, qui passe dans un état de fonctionnement donné à l'avance du système (4) de convertisseur,
- on compare à une référence le courant (I_{Z,2f_{AC1}}) de circuit intermédiaire à la fréquence du réseau doublée et/ou une grandeur, qui s'en déduit, et
- on contrôle l'accord du circuit d'absorption en utilisant un résultat de la comparaison,
**caractérisé en ce que**
pour la détermination de l'état de fonctionnement donné à l'avance, on établit une puissance (P_{Z}) électrique, que l'on injecte dans le circuit (12) intermédiaire.

2. Procédé suivant la revendication 1,
**caractérisé en ce que**
la puissance (P_{Z}) électrique, que l'on injecte dans le circuit (12) intermédiaire est une puissance (P_{Z}) électrique positive ou négative, que l'on injecte du convertisseur (8) d'entrée dans le circuit (12) intermédiaire.

3. Procédé suivant l'une des revendications précédentes, **caractérisé en ce qu'**
il est prescrit, pour l'état de fonctionnement donné à l'avance, une puissance (P_{Z}) électrique déterminée, que l'on injecte dans le circuit (12) intermédiaire,
de manière à comparer à la référence au moins le courant (I_{Z,2f_{AC1}}) de circuit intermédiaire à la fréquence du réseau doublée, qui passe à l'instant où la puissance (P_{Z}) électrique déterminée donnée à l'avance est injectée dans le circuit (12) intermédiaire, et/ou une grandeur déduite de ce courant (I_{Z,2f_{AC1}}) de circuit intermédiaire à la fréquence du réseau doublée.

4. Procédé suivant la revendication 3,
**caractérisé en ce que** l'
on compare à la référence au moins le courant (I_{Z,2f_{AC1}}) de circuit intermédiaire à la fréquence du réseau doublée, qui passe à l'instant où une puissance (Pₘₐₓ₊, Pₘₐₓ₋) électrique maximum est injectée dans le circuit (12) intermédiaire, et/ou une grandeur déduite de ce courant (I_{Z,2f_{AC1}}) de circuit intermédiaire à la fréquence du réseau doublée.

5. Procédé suivant l'une des revendications 1 à 4,
**caractérisé en ce que** l'
on établit le courant (I_{Z,2f_{AC1}}) de circuit intermédiaire à la fréquence du réseau doublée au moins pendant un intervalle de temps donné à l'avance, on établit au moins pendant l'intervalle de temps donné à l'avance la puissance (P_{Z}) électrique, que l'on injecte dans le circuit (12) intermédiaire, et
pour le contrôle de l'accord du circuit d'absorption, on contrôle, si dans l'intervalle de temps donné à l'avance, il y a une corrélation donnée à l'avance entre le courant (I_{Z,2f_{AC1}}) de circuit intermédiaire à la fréquence du réseau doublée ou une grandeur, qui s'en déduit, et la puissance (P_{Z}) électrique.

6. Procédé suivant l'une des revendications précédentes,
**caractérisé en ce que**
la grandeur, que l'on déduit d'au moins le courant (I_{Z,2f_{AC1}}) de circuit intermédiaire à la fréquence du réseau doublée, qui passe dans l'état de fonctionnement donné à l'avance, est une impédance (Z_{2f_{AC1}}) du circuit (12) intermédiaire à la fréquence (2f_{AC1}) du réseau doublée.

7. Procédé suivant l'une des revendications précédentes,
**caractérisé en ce que**
la référence est un courant et/ou une grandeur, qui s'en déduit,
- qui (r) a été établie/est établie en utilisant des courants (I_{Z,2f_{AC1}}) antérieurs de circuit intermédiaire à la fréquence du réseau doublée du même système (4) de convertisseur et/ou
- qui (r) a été établie/est établie en utilisant des courants (I_{Z,2f_{AC1}}) de circuit intermédiaire à la fréquence du réseau doublée d'un ou de plusieurs systèmes comparables de convertisseur.

8. Procédé suivant l'une des revendications précédentes,
**caractérisé en ce que**,
si l'on constate qu'au moins le courant (I_{Z,2f_{AC1}}) de circuit intermédiaire à la fréquence du réseau doublée, qui passe dans un état de fonctionnement donné à l'avance, et/ou une grandeur déduite de ce courant (I_{Z,2f_{AC1}}) de circuit intermédiaire à la fréquence du réseau doublée s'écarte de plus d'une tolérance donnée à l'avance de la référence, l'accord réel du circuit (16) d'absorption ne correspond pas à un accord prévu.

9. Procédé suivant l'une des revendications précédentes, **caractérisé en ce que** l'
on établit en fonction du temps, une tension (U_{Z}) de circuit intermédiaire s'appliquant au circuit (12) intermédiaire,
on établit une ondulation (ω) au moins de la tension (U_{Z}) de circuit intermédiaire, qui s'applique dans l'état de fonctionnement donné à l'avance et on la compare à une ondulation de référence,
et on contrôle l'accord du circuit d'absorption en utilisant la comparaison mentionnée en dernier.

10. Procédé suivant l'une des revendications précédentes, **caractérisé en ce que**,
si l'on constate lors du contrôle, que l'accord réel du circuit (16) d'absorption ne correspond pas à un accord prévu,
- on effectue un entretien du système (4) de convertisseur, en particulier du circuit (16) d'absorption et/ou
- on connecte et/ou déconnecte des condensateurs connectables ou déconnectables du circuit (16) d'absorption.

11. Unité (6) de contrôle pour le contrôle d'un accord d'un circuit (16) d'absorption disposé dans un circuit (12) intermédiaire d'un système (4) de convertisseur, dans laquelle le circuit (12) intermédiaire est monté entre un convertisseur (8) d'entrée et un convertisseur (10) de sortie du système (4) de convertisseur,
dans laquelle
l'unité (6) de contrôle est agencée pour,
- en utilisant un courant (I_{Z}) de circuit intermédiaire entrant dans le circuit (12) intermédiaire, établir un courant (I_{Z,2f_{AC1}}) de circuit intermédiaire à la fréquence du réseau doublée,
- déterminer un état de fonctionnement donné à l'avance à cet effet du système (4) de convertisseur,
- comparer à une référence le courant (I_{Z,2f_{AC1}}) de circuit intermédiaire à la fréquence du réseau doublée et/ou une grandeur, qui s'en déduit, et
- contrôler l'accord du circuit d'absorption en utilisant un résultat de la comparaison,
**caractérisée en ce que**
l'unité de contrôle est agencée, pour établir pour la détermination de l'état de fonctionnement donné à l'avance, une puissance (P_{Z}) électrique, qui est injectée dans le circuit (12) intermédiaire.

12. Système (2) comprenant l'unité (6) de contrôle suivant la revendication 11 et un système (4) de convertisseur, qui comprend un convertisseur (8) d'entrée, un convertisseur (10) de sortie et un circuit (12) intermédiaire monté entre le convertisseur (8) d'entrée et le convertisseur (10) de sortie, dans lequel un circuit (16) d'absorption est disposé dans le circuit (12) intermédiaire.

13. Système (2) suivant la revendication 12,
**caractérisé en ce que**
le convertisseur (8) d'entrée est un redresseur, en particulier un convertisseur quatre quadrants.

14. Système (2) suivant la revendication 12 ou 13,
**caractérisé en ce que**
le convertisseur (10) de sortie est un onduleur, en particulier un onduleur pulsé.
